# EUROPÄISCHE PATENTSCHRIFT

(11) **EP 0 394 767 B1**
(45) Veröffentlichungstag und Bekanntmachung des Hinweises auf die Patenterteilung: **27.12.1996**
(21) Anmeldenummer: 90107014.4
(22) Anmeldetag: 12.04.1990
(51) Int. Cl.: H01L 23/373, H01L 23/29

(54) **Planarisierendes Dielektrikum**
Dielectric for planarization
Diélectrique pour planarisation

(30) Priorität: 27.04.1989 DE 3913981
(43) Veröffentlichungstag der Anmeldung: 31.10.1990
(73) Patentinhaber: SIEMENS AKTIENGESELLSCHAFT, 80333 München (DE)
(72) Erfinder: Birkle, Siegfried, Dr., D-8552 Höchstadt (DE); Hammerschmidt, Albert, Dr., D-8520 Erlangen (DE); Kammermaier, Johann, Dr., D-8025 Unterhaching (DE); Leuschner, Rainer, Dr., D-8521 Grossenseebach (DE); Schulte, Rolf W., D-8520 Erlangen (DE)

(56) Entgegenhaltungen:
- EP-A- 0 257 466
- GB-A- 2 089 126
- PATENT ABSTRACTS OF JAPAN, Band 7, Nr. 148 (E-184)[1293], 29. Juni 1983; & JP-A-58 60 563
- IDEM
- POLYIMIDES, Band 2, 1984, Seiten 783-793, Editor K.L. MITTAL,, Plenum Press, New York, US; C.C. CHAO et al.: "Planarization enhancement of polyimides by dynamic curing and the effect of multiple coating"
- IBM TECHNICAL DISCLOSURE BULLETIN, Band 31, Nr. 11, April 1989, Seiten 355-357, New York, US; "Thermally conducting and electrically insulating chemical coating"
- Polymer Letters, Band 2, Seiten 655-659, 1964
- IDR-Industrie Diamanten Rundschau, Band 18, Nr. 4, Seiten 249-253, 1984.

## Beschreibung

Zur Planarisierung der Topographie in elektronischen Bauelementen werden häufig hochtemperaturbeständige organische Dielektrika eingesetzt (siehe dazu beispielsweise: K. L. Mittal, "Polyimides", Vol. 2, Seiten 767 bis 793, Plenum Press New York, 1984), die aus Lösungen, beispielsweise mittels Spin-coating oder Sprühbeschichtung, aufgetragen werden. Neben guten Planarisierungs- und Isolationseigenschaften werden dabei eine niedrige Dielektrizitätszahl, was eine hohe Schaltgeschwindigkeit ermöglicht, und ein niedriger Verlustfaktor bei hoher Wärmeleitfähigkeit gefordert, um hohe Packungsdichten realisieren zu können. Außerdem muß eine Strukturierbarkeit des Dielektrikums gewährleistet sein.

Mit den aus heutiger Sicht für die Mikroelektronik verfügbaren planarisierenden organischen Dielektrika lassen sich die genannten Forderungen nicht erfüllen, insbesondere nicht hinsichtlich einer hohen Wärmeleitfähigkeit. Bei der Entwicklung integrierter Schaltungen mit hoher Packungsdichte sind deshalb die Anwendungsmöglichkeiten für planarisierende organische Dielektrika stark eingeschränkt. Zur Planarisierung alternativ eingesetzte anorganische Schichten bzw. Dielektrika, beispielsweise aus SiO₂ (siehe dazu: V. Grewal et al., June 9-10, 1986 V-MIC Conf., Seiten 107 bis 113), die aus der Gasphase abgeschieden werden, erfordern andererseits eine aufwendige Technologie. Außerdem kann mit diesen Dielektrika zwar eine hohe Wärmeleitfähigkeit erzielt werden, sie besitzen jedoch deutlich schlechtere dielektrische Eigenschaften als die organischen Dielektrika.

Aufgabe der Erfindung ist es, ein planarisierendes Dielektrikum anzugeben, das sowohl gute Planarisierungs- und Isolationseigenschaften als auch eine niedrige Dielektrizitätszahl, einen niedrigen Verlustfaktor und eine hohe Wärmeleitfähigkeit besitzt, und das darüber hinaus strukturierbar ist.

Dies wird erfindungsgemäß dadurch erreicht, daß das Dielektrikum aus einer Matrix aus einem hochtemperaturbeständigen organischen Polymeren besteht, in die in feiner Verteilung Diamant als Füllstoff eingelagert ist.

Beim Gegenstand der Erfindung werden die dielektrischen und auch die planarisierenden Eigenschaften der Kunststoffmatrix durch den Füllstoff, der elektrisch nicht-leitend, d.h. isolierend ist (spezifischer Widerstand > 10¹⁰ Ω.cm), nur unwesentlich beeinflußt, die Wärmeleitfähigkeit dagegen entscheidend erhöht. Durch den Füllstoff wird außerdem die Ätzbarkeit des Dielektrikums in einem Sauerstoffplasma nicht beeinträchtigt.

Beim erfindungsgemäßen planarisierenden Dielektrikum beträgt der Anteil des Füllstoffes vorteilhaft bis zu 30 Vol.-%. Der Füllstoff ist Diamant, dessen spezifischer elektrischer Widerstand ca. 10¹⁶ Ω.cm beträgt.

Von Vorteil ist beim Erfindungsgegenstand ferner, wenn der Füllstoff, der in pulverisierter Form verwendet wird, eine Partikelgröße < 50 nm aufweist.

Die Kunststoffmatrix besteht beim erfindungsgemäßen Dielektrikum vorteilhaft aus sogenannten Leiter- oder Halb-Leiterpolymeren, die hochtemperaturbeständig sind. Leiterpolymere ("ladder polymers") sind Hochpolymere, deren Moleküle aus Ketten von kondensierten Ringen bestehen, so daß ihre Struktur dem Bild einer Sprossenleiter ähnelt. Derartige Polymere sind beispielsweise Polyimidazopyrrolone. Halb-Leiterpolymere sind beispielsweise Polyimide, Polyimidazole und Polyoxazole. Bevorzugt besteht beim erfindungsgemäßen Dielektrikum die Kunststoffmatrix aus einem Polybenzoxazol (siehe dazu beispielsweise: E. Behr, "Hochtemperaturbeständige Kunststoffe", Carl Hanser Verlag München, 1969, Seiten 71 und 72 sowie 99 und 100).

Als Kunststoffmatrix dient ein Polybenzoxazol, das eine Wärmeleitfähigkeit von 0,19 W/K.m aufweist; die Dielektrizitätszahl beträgt 2,8. Eine lösliche Vorstufe des Polybenzoxazols in Form eines Hydroxypolyamids wird aus 2.2-Bis(3-amino-4-hydroxyphenyl)-1.1.1.3.3.3-hexafluorpropan (50 Mol-%), 3.3'-Dihydroxybenzidin (50 Mol-%) und Isophthalsäuredichlorid (90 Mol-%) hergestellt (siehe dazu: "Polym. Letters", Vol. 2 (1964), Seiten 655 bis 659).

Als ein Beispiel, das nicht unter den Schutzbereich des Anspruchs fällt, wird in einer ca. 20 bis 30 %igen Lösung der Polybenzoxazol-Vorstufe in N-Methylpyrrolidon pulverisierter amorpher, wasserstoffhaltiger Kohlenstoff, vorzugsweise mit einer Partikelgröße < 50 nm, dispergiert. Dieser Kohlenstoff weist einen spezifischen elektrischen Widerstand > 10¹² Ω.cm, eine Dielektrizitätszahl von 6 und eine Wärmeleitfähigkeit von 1000 W/K.m auf.

Die in der vorstehend beschriebenen Weise erhaltene Dispersion wird auf einen Aluminium-Leiterbahnen aufweisenden Siliciumwafer aufgeschleudert, dann wird bei ca. 100°C im Umluftofen vorgetrocknet (Dauer: ca. 20 min). Nachfolgend wird im Diffusionsofen unter Stickstoff als Inertgas getempert, wobei folgendes Temperaturprogramm durchlaufen wird: 1 h bis 170°C, 1 h bis 250°C, 1 h bis 400°C, 1 h bei 400°C, 6 h bis Raumtemperatur. Während des Temperprozesses wird die Polymervorstufe in hochtemperaturbeständiges Polybenzoxazol übergeführt.

## Patentansprüche

1. Planarisierendes Dielektrikum, insbesondere für elektronische Bauelemente, **dadurch gekennzeichnet**, daß es aus einer Matrix aus einem hochtemperaturbeständigen organischen Polymer besteht, in die in feiner Verteilung Diamant als Füllstoff eingelagert ist.

2. Planarisierendes Dielektrikum nach Anspruch 1, **dadurch gekennzeichnet**, daß der Anteil des Füllstoffes bis zu 30 Vol.-% beträgt.

3. Planarisierendes Dielektrikum nach Anspruch 1 oder 2, **dadurch gekennzeichnet**, daß der Füllstoff eine Partikelgröße < 50 nm aufweist.

4. Planarisierendes Dielektrikum nach einem der Ansprüche 1 bis 3, **dadurch gekennzeichnet**, daß das Polymer ein Leiter- oder Halb-Leiterpolymer ist.

5. Planarisierendes Dielektrikum nach Anspruch 4, **dadurch gekennzeichnet**, daß das Polymer Polybenzoxazol ist.

## Claims

1. Planarizing dielectric, in particular for electronic components, characterized in that it consists of a matrix of a high-temperature resistant organic polymer, into which a fine distribution of diamond as filler is intercalated.

2. Planarizing dielectric according to claim 1, characterized in that the portion of the filler amounts to up to 30% by volume.

3. Planarizing dielectric according to claim 1 or 2, characterized in that the filler has a particle size < 50 nm.

4. Planarizing dielectric according to one of claims 1 to 3, characterized in that the polymer is a ladder or semi-ladder polymer.

5. Planarizing dielectric according to claim 4, characterized in that the polymer is polybenzoxazole.

## Revendications

1. Diélectrique pour planarisation, en particulier pour des composants électroniques, caractérisé en ce qu'il est composé d'une matrice confectionnée dans un polymère organique à haute résistance thermique, dans laquelle est finement dispersé du diamant comme matière de charge.

2. Diélectrique pour planarisation selon la revendication 1, caractérisé en ce que la part de la matière de charge peut atteindre 30 % en volume.

3. Diélectrique pour planarisation selon l'une des revendications 1 ou 2, caractérisé en ce que la matière de charge présente une taille de particule inférieure à 50 nm.

4. Diélectrique pour planarisation selon l'une des revendications 1 à 3, caractérisé en ce que le polymère est un polymère échelle ou demi-échelle.

5. Diélectrique pour planarisation selon la revendication 4, caractérisé en ce que le polymère est du polybenzoxazole.
